(19) Europäisches Patentamt / European Patent Office / Office européen des brevets

(11) **EP 2 463 741 A1**

(12) **DEMANDE DE BREVET EUROPEEN**

(43) Date de publication:
**13.06.2012 Bulletin 2012/24**

(51) Int Cl.:
*G06F 1/10* (2006.01)     *H03L 7/00* (2006.01)
*H04L 7/00* (2006.01)

(21) Numéro de dépôt: **11192350.4**

(22) Date de dépôt: **07.12.2011**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **13.12.2010 FR 1060427**

(71) Demandeur: **Commissariat à l'Énergie Atomique et aux Énergies Alternatives 75015 Paris (FR)**

(72) Inventeurs:
• **Korniienko, Anton**
 **69003 Lyon (FR)**
• **Colinet, Eric**
 **Pasadena, CA California 91106 (US)**

(74) Mandataire: **Ilgart, Jean-Christophe et al Brevalex 95, rue d'Amsterdam 75378 Paris Cedex 8 (FR)**

(54) **Dispositif et procédé de compensation de délai de propagation d'un signal**

(57) Dispositif (100) de compensation d'un délai τ subi par un premier signal *ref(t)* périodique lors d'une propagation entre une première (106) et une seconde extrémité (108) d'une première liaison de transmission (104), comportant au moins :
- des premiers moyens (114) aptes à générer un deuxième signal *ref(t+τ)* correspondant au premier signal *ref(t)* dont la phase est avancée d'une durée égale au délai τ,
- des seconds moyens (116) aptes à générer, à partir d'un troisième signal *ref(t-τ)* obtenu à la seconde extrémité de la première liaison de transmission et correspondant au premier signal *ref(t)* dont la phase est retardée du délai τ, et à partir du deuxième signal *ref(t+τ)*, un quatrième signal en phase avec le premier signal *ref(t)*.

FIG.5

EP 2 463 741 A1

**Description**

**DOMAINE TECHNIQUE**

L'invention concerne un dispositif et un procédé permettant de compenser un délai de propagation d'un signal à travers une liaison de transmission, notamment une liaison électrique. L'invention s'applique tout particulièrement au domaine de la génération et de la synchronisation de signaux d'horloges distribués, utilisés par exemple pour la synchronisation d'un ou plusieurs dispositifs électriques et/ou électroniques tels que des microprocesseurs, et/ou dans le domaine des télécommunications.

**ÉTAT DE LA TECHNIQUE ANTÉRIEURE**

Dans un système électrique et/ou électronique synchrone, un signal d'horloge permet de définir une référence temporelle servant notamment à réaliser une propagation synchrone de données dans le système et un cadencement des différents éléments du système. Un système synchrone sur puce, par exemple un microprocesseur, comporte généralement un arbre balancé, ou équilibré, de distribution de signaux d'horloge permettant de distribuer des signaux d'horloge depuis une source jusqu'aux éléments du système à cadencer. La synchronisation des signaux d'horloge générés est obtenue en égalisant les délais de propagation du signal d'horloge provenant de la source dans chacune des branches du système dans lesquelles le signal d'horloge est distribué.

Pour les circuits de systèmes multiprocesseurs, il est très compliqué, et parfois impossible, de réaliser un arbre de distribution de signaux d'horloge parfaitement équilibré. Cet équilibrage est souvent imprécis et une désynchronisation des signaux d'horloge peut donc apparaitre dans ces circuits. De plus, lorsqu'un élément supplémentaire est ajouté au système existant, par exemple un microprocesseur supplémentaire, cela peut nécessiter de redimensionner la totalité de l'arbre de distribution de signaux d'horloge. Enfin, un défaut dans une des branches de l'arbre de distribution de signaux d'horloge peut facilement affecter une grande partie du système parallèle dépendant de l'emplacement de la défaillance.

Un autre inconvénient d'un tel arbre de distribution de signaux d'horloge est sa consommation de puissance importante, qui est dissipée en partie sous forme de chaleur. Cette surconsommation est causée notamment par la forte impédance parasite des larges branches de distribution de l'arbre, provoquant une augmentation du temps de montée du signal d'horloge et donc du délai. Cette consommation devient encore plus critique lorsque l'arbre fonctionne à haute fréquence.

Par ailleurs, même lorsque l'arbre de distribution de signaux d'horloge est bien conçu et équilibré, en respectant toutes les longueurs de branches sans défaillance, il existe toujours d'importantes sources d'imperfections du type « skew » (déphasage par rapport à la valeur nominale de l'horloge) et « jitter » (oscillations autour de la valeur nominale de l'horloge) qui sont liées notamment à l'utilisation de buffers dans l'arbre de distribution de signaux d'horloge, servant de répéteurs du signal d'horloge, et à la diaphonie entre les lignes. Ces imperfections sont particulièrement critiques pour des signaux d'horloge de fréquence élevée. De plus, en raison de l'augmentation des fréquences des signaux d'horloge, il peut arriver que le « skew » d'horloge à travers la puce soit comparable au cycle d'horloge, provoquant inévitablement des erreurs de calcul.

En alternative à l'arbre classique de distribution de signaux d'horloge, il est possible d'utiliser un réseau distribué de PLL (boucle à verrouillage de phase, ou boucle à phase asservie) aux entrées multiples, interconnectées, ou couplées, entre elles, chaque PLL générant un signal d'horloge local synchronisé de manière active avec les autres PLL. De manière générale, une PLL est composée d'un ou plusieurs comparateurs de phases (également appelés détecteurs de phases), d'un VCO (oscillateur commandé en tension) et d'un correcteur assurant le contrôle du VCO pour se synchroniser par rapport à un signal d'horloge de référence. On dit qu'un ensemble d'oscillateurs est synchronisé en termes de phase et de fréquence lorsque chacun des oscillateurs oscille sur une même fréquence avec une même phase. La synchronisation est qualifiée d'active lorsque la mesure et la compensation du déphasage se font en temps réel, ce qui permet, à chaque instant, de remédier aux problèmes liés à l'influence de toutes les perturbations possibles (température, impédance parasite, dispersion, vieillissement, défaillance, etc.).

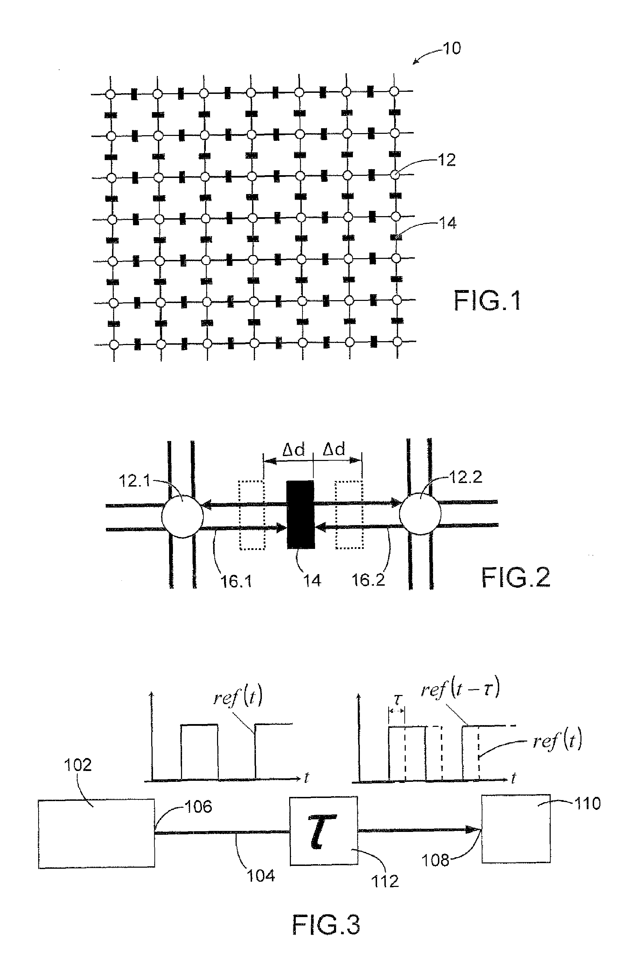

Un exemple d'un tel réseau distribué 10 de PLL est représenté sur la figure 1. Ce réseau 10 possède des noeuds 12, chaque noeud 12 comportant un VCO, un additionneur et un correcteur fournissant au VCO un signal de commande définissant la fréquence d'oscillation du VCO. Un ou plusieurs noeuds 12 du réseau distribué 10 ne sont pas formés par un VCO et son correcteur associé mais par une ou plusieurs sources oscillantes synchrones formant une horloge maître sur laquelle vont se synchroniser les oscillateurs formés par les autres noeuds 12 du réseau distribué 10. Les noeuds 12 forment des générateurs de signaux d'horloge séparés spatialement les uns des autres et reliés entre eux sous la forme d'une grille régulière en deux dimensions. Des comparateurs, ou détecteurs, de phases 14 disposés entre les noeuds 12 fournissent l'erreur de phase d'un VCO par rapport au VCO voisin. Chaque VCO des noeuds 12 forme, avec les comparateurs de phases 14 qui lui sont adjacents, une PLL. Les erreurs de phase provenant des noeuds voisins (par exemple au nombre de 4 lorsque l'on considère un noeud 12 ne se trouvant pas au niveau d'un bord du réseau 10) de chacun des noeuds 12 sont additionnées et filtrées à l'intérieur de ce noeud et sont utilisées pour ajuster la phase du VCO de ce noeud afin de la rendre égale à la phase moyenne des noeuds voisins. Ainsi, lorsque la phase du signal d'horloge produit à chaque noeud 12 est synchronisé avec la phase moyenne des signaux d'horloge produits au niveau de ses noeuds voisins, l'ensemble du réseau distribué 10 est censé être globalement synchronisé en fréquence et en phase.

Dans cette architecture, au lieu d'utiliser de larges branches de distribution, on n'utilise donc de simples lignes électriques permettant l'interconnexion des noeuds voisins, compensant ainsi de manière systématique les délais de propagation. De plus, en utilisant des diviseurs de fréquence à l'intérieur de chaque noeud, il est possible de distribuer le signal d'horloge en basse fréquence tout en gardant des fréquences locales (au niveau des noeuds) élevées.

Il est toutefois possible que dans une telle architecture, un délai de propagation entre deux noeuds adjacents apparaisse. Dans ce cas, chaque PLL ne se synchronise pas avec les signaux réellement délivrés par les PLL voisines, mais avec des signaux retardés. Un tel délai peut alors s'accumuler dans la puce à travers les noeuds et au final, empêcher le réseau de se synchroniser.

Afin de tenter d'empêcher l'apparition d'un tel délai de propagation, le document US 7 571 359 propose de disposer les comparateurs de phases partagés entre deux noeuds de PLLs voisines à distance égale de ces deux noeuds. Ainsi, comme représenté sur la figure 2, pour un comparateur de phases 14 disposé entre deux noeuds 12.1 et 12.2 et dont le signal de sortie est envoyé à ces deux noeuds 12.1 et 12.2, les distances entre ce comparateur de phases 14 et chacun des noeuds 12.1 et 12.2 sont donc choisies comme étant égales. Si le comparateur de phases 14 est placé exactement au milieu, à distance égale des noeuds 12.1 et 12.2, les deux signaux d'horloge venant de ces noeuds 12.1 et 12.2 (représentés par les flèches 16.1 et 16.2) sont retardés de manière égale, le déphasage entre les signaux générés par les PLLs voisines étant alors auto-compensé. Il en est de même des signaux envoyés depuis le comparateur de phases 14 jusqu'aux noeuds 12.1 et 12.2.

En pratique, et notamment à cause des dispersions technologiques, de la dilatation thermique ou d'une insuffisance de place lors de la réalisation d'un tel réseau distribué de PLL, le comparateur de phases 14 n'est jamais disposé exactement au milieu, entre les noeuds 12.1 et 12.2. Comme représenté sur la figure 2, il existe toujours un décalage $\Delta d$ de la position réelle du comparateur de phases 14 par rapport à la position théorique équidistante des deux noeuds 12.1 et 12.2, ce décalage pouvant provoquer un déphasage (« skew ») entre les deux signaux d'horloge générés. De plus, étant donné que les liaisons électriques entre le comparateur de phases 14 et les noeuds 12.1 et 12.2 sont physiquement distinctes, une perturbation (par exemple une variation de la température, de l'alimentation électrique, etc.) n'impacte qu'une seule de ces liaisons électriques. En raison de cette asymétrie, une telle perturbation génère donc un déphasage des signaux d'horloge de ces noeuds 12.1 et 12.2 et appliqués en entrée du comparateur de phases 14.

Le document de Hong-Yean Hsieh et al., "Self-calibrating clock distribution with scheduled skews," Proc. ISCAS 1998, pp. 470-473, décrit un système permettant de compenser les délais dans un arbre de distribution de signaux d'horloge. Pour chacune des liaisons électriques dans lesquelles un signal d'horloge est destiné à être distribué, le système réalise une mesure du temps de propagation aller-retour du signal d'horloge dans ces liaisons électriques. Des moyens de calcul arithmétique déterminent ensuite par calcul les différents déphasages à appliqués aux signaux, les signaux d'horloge étant ensuite propagés depuis la source avec un retard approprié afin de compenser les délais de propagation induits par les lignes électriques de l'arbre de distribution.

Un tel système a pour inconvénient majeur d'être complexe à mettre en oeuvre et nécessite des éléments coûteux (grand nombre d'étages inverseurs, multiplexeur, de logique arithmétique et de contrôle). De plus, ce système nécessite de distribuer les signaux en haute fréquence.

## EXPOSÉ DE L'INVENTION

Un but de la présente invention est de proposer un dispositif et un procédé de compensation de délai, ou retard, de propagation d'un ou plusieurs signaux, tels que des signaux électriques sur une ou plusieurs liaisons de transmission, permettant de réaliser automatiquement une compensation du délai de propagation, et ne nécessitant pas de moyens de calcul complexes pour sa mise en oeuvre.

Pour cela, la présente invention propose un dispositif de compensation d'un délai $\tau$ subi par un premier signal *ref(t)* lors d'une propagation entre une première et une seconde extrémité d'une première liaison de transmission, comportant au moins :

- des premiers moyens aptes à générer un deuxième signal *ref(t+τ)* correspondant au premier signal *ref(t)* dont la phase est avancée d'une durée égale au délai $\tau$,
- des seconds moyens aptes à générer, à partir d'un troisième signal *ref(t-τ)* obtenu à la seconde extrémité de la première liaison de transmission et correspondant au premier signal *ref(t)* dont la phase est retardée du délai $\tau$, et

à partir du deuxième signal *ref(t+τ),* un quatrième signal en phase avec le premier signal *ref(t).*

Un tel dispositif forme une solution au problème des délais de propagation des signaux d'horloge, réalisant une compensation du délai de propagation dans une liaison de transmission en formant un système de correction automatique réalisé au niveau de la liaison de transmission.

Le premier signal *ref(t)* est un signal périodique.

Le dispositif selon l'invention se base sur le principe des boucles à verrouillage de phase (PLL) et peut être facilement appliqué à un réseau de distribution de signaux d'horloge, par exemple de type arbre de distribution ou réseau de PLL. Le dispositif selon l'invention peut également réaliser une compensation de délai de propagation d'un signal dans une simple liaison de transmission. Le dispositif selon l'invention va générer de manière automatique un signal d'horloge en avance de phase dont la valeur est égale à la valeur du retard induit par le chemin de propagation formé par la liaison de transmission. A partir de ces deux signaux, le dispositif peut donc générer en sortie un signal en phase et synchrone avec le signal d'origine.

L'expression « liaison de transmission » désigne n'importe quel type de liaison sur laquelle il est possible de transmettre un signal. Une telle liaison sera avantageusement une liaison électrique, telle que par exemple un fil électrique, une ligne électrique, une piste conductrice, etc. Toutefois, l'invention peut également s'appliquer à d'autres types de liaisons de transmission: liaisons optiques, électromagnétiques, etc.

Les premiers moyens aptes à générer le deuxième signal *ref(t+τ)* peuvent comporter au moins :

- un comparateur de phases apte à comparer une phase du premier signal *ref(t)* et une phase d'un signal obtenu à une première extrémité d'une deuxième liaison de transmission apte à retarder d'un délai sensiblement égal à τ un signal, tel qu'un signal électrique, propagé sur ladite deuxième liaison de transmission,
- un oscillateur commandé en tension dont une sortie, correspondant à une sortie desdits premiers moyens, est reliée, par exemple électriquement, à une seconde extrémité de la deuxième liaison de transmission,
- une troisième liaison de transmission apte à retarder d'un délai sensiblement égal à τ un signal, par exemple un signal électrique, propagé sur ladite troisième liaison de transmission, comprenant une première extrémité couplée, par exemple électriquement, à une sortie du comparateur de phases et une seconde extrémité couplée, par exemple électriquement, à une entrée de l'oscillateur commandé en tension.

Le comparateur de phases peut comporter une première entrée couplée, par exemple électriquement, à la première extrémité de la première liaison de transmission et une seconde entrée couplée, par exemple électriquement, à une première extrémité de la deuxième liaison de transmission.

Les premiers moyens aptes à générer le deuxième signal *ref(t+τ)* peuvent comporter en outre un filtre passe-bas, la première extrémité de la troisième liaison de transmission étant couplée, par exemple électriquement, à la sortie du comparateur de phases au moins par l'intermédiaire dudit filtre passe-bas ou la seconde extrémité de la troisième liaison de transmission étant couplée, par exemple électriquement, à l'entrée de l'oscillateur commandé en tension au moins par l'intermédiaire dudit filtre passe-bas.

Les premiers moyens aptes à générer le deuxième signal *ref(t+τ)* peuvent comporter au moins :

- un comparateur de phases apte à comparer une phase du premier signal *ref(t)* et une phase d'un signal obtenu à une première extrémité d'une deuxième liaison de transmission apte à retarder d'un délai sensiblement égal à τ un signal propagé sur ladite deuxième liaison de transmission,
- un filtre passe-bas dont une entrée est reliée à une sortie du comparateur de phases,
- un oscillateur commandé en tension dont une entrée est reliée à une sortie du filtre passe-bas,
- une troisième liaison de transmission apte à retarder d'un délai sensiblement égal à τ un signal propagé sur ladite troisième liaison de transmission, comprenant une première extrémité reliée à une sortie de l'oscillateur commandé en tension et une seconde extrémité, correspondant à une sortie desdits premiers moyens, reliée à une seconde extrémité de la deuxième liaison de transmission.

Selon une variante de réalisation, les premiers moyens aptes à générer le deuxième signal *ref(t+τ)* peuvent comporter au moins :

- un comparateur de phases apte à comparer une phase du premier signal *ref(t)* et une phase d'un signal obtenu à une première extrémité d'une deuxième liaison de transmission apte à retarder d'un délai sensiblement égal à τ un signal propagé sur ladite deuxième liaison de transmission,
- un filtre passe-bas dont une entrée est couplée à une sortie du comparateur de phases,
- une ligne à retards commandée en tension comprenant une première entrée couplée à une sortie du filtre passe-bas et une seconde entrée sur laquelle le premier signal *ref(t)* est destiné à être appliqué,

- une troisième liaison de transmission apte à retarder d'un délai sensiblement égal à τ un signal propagé sur ladite troisième liaison de transmission, interposée entre le comparateur de phases et le filtre passe-bas, ou entre le filtre passe-bas et la ligne à retards commandée en tension, ou entre la ligne à retards commandée en tension et la deuxième liaison de transmission. Dans ce cas, lorsque la troisième liaison de transmission est interposée entre le comparateur de phases et le filtre passe-bas ou entre le filtre passe-bas et la ligne à retards commandée en tension, la sortie desdits premiers moyens peut correspondre à la sortie de la ligne à retards commandée en tension. Par contre, lorsque la troisième liaison de transmission est interposée entre la ligne à retards commandée en tension et la deuxième liaison de transmission, la sortie desdits premiers moyens peut correspondre à l'extrémité de la troisième liaison de transmission qui est reliée à l'extrémité de la deuxième liaison de transmission.

Les seconds moyens aptes à générer le quatrième signal peuvent comporter au moins une boucle à verrouillage de phase apte à générer en sortie le quatrième signal.

Dans ce cas, la boucle à verrouillage de phase peut comporter au moins :

- un premier comparateur de phases apte à comparer une phase du troisième signal *ref(t-τ)* obtenu à la seconde extrémité de la première liaison de transmission et une phase du quatrième signal obtenu en sortie de la boucle à verrouillage de phase,
- un second comparateur de phases apte à comparer une phase du deuxième signal *ref(t+τ)* obtenu en sortie desdits premiers moyens et une phase du quatrième signal obtenu en sortie de la boucle à verrouillage de phase,

- des moyens d'addition de signaux obtenus en sortie du premier et du second comparateur de phases,
- un atténuateur du signal obtenu en sortie des moyens d'addition, de gain égal à environ 0,5,
- un filtre passe-bas apte à filtrer le signal obtenu en sortie des moyens d'addition,
- un oscillateur commandé en tension comprenant une entrée reliée, par exemple électriquement, à une sortie du filtre passe-bas et une sortie correspondant à la sortie de la boucle à verrouillage de phase et couplée, par exemple électriquement, à une entrée du premier comparateur de phases et à une entrée du second comparateur de phases.

Dans une première configuration, la sortie des moyens d'addition peut être reliée à l'entrée de l'atténuateur, et la sortie de l'atténuateur peut être reliée à l'entrée du filtre passe-bas. Dans une deuxième configuration, la sortie des moyens d'addition peut être reliée à l'entrée du filtre passe-bas. Dans ce cas, il est possible que le filtre passe-bas forme également, c'est-à-dire remplisse le rôle de, l'atténuateur, le gain statique du filtre passe-bas pouvant incorporer le gain d'atténuation.

La sortie de l'oscillateur commandé en tension de la boucle à verrouillage de phase peut être directement reliée auxdites entrées du premier et du second comparateur de phases.

Dans une variante, la boucle à verrouillage de phase peut comporter en outre un diviseur de fréquence dont une entrée peut être reliée, par exemple électriquement, à la sortie de l'oscillateur commandé en tension et dont une sortie peut être reliée, par exemple électriquement, auxdites entrées du premier et du second comparateur de phases, le premier et le second comparateur de phases étant dans ce cas respectivement aptes à comparer une phase du troisième signal *ref(t-τ)* et une phase du deuxième signal *ref(t+τ)* avec une phase du signal obtenu en sortie du diviseur de fréquence.

Les seconds moyens aptes à générer le quatrième signal peuvent comporter au moins une boucle à verrouillage de retard apte à générer en sortie le quatrième signal.

De manière générale, une boucle à verrouillage de retard (DLL) peut comporter un comparateur de phase, une ligne à retards commandée en tension (VCDL) et un correcteur assurant le contrôle de la VCDL pour se synchroniser par rapport à un signal de référence.

La boucle à verrouillage de retard peut comporter au moins :

- un premier comparateur de phases apte à comparer une phase du troisième signal *ref(t-τ)* obtenu à la seconde extrémité de la première liaison de transmission et une phase du quatrième signal obtenu en sortie de la boucle à verrouillage de retard,
- un second comparateur de phases apte à comparer une phase du deuxième signal *ref(t+τ)* obtenu en sortie desdits premiers moyens et une phase du quatrième signal obtenu en sortie de la boucle à verrouillage de retard,

- des moyens d'addition de signaux obtenus en sortie du premier et du second comparateur de phases,
- un atténuateur du signal obtenu en sortie des moyens d'addition, de gain égal à environ 0,5,
- un filtre passe-bas apte à filtrer le signal obtenu en sortie des moyens d'addition,
- une ligne à retards commandée en tension comprenant une première entrée reliée, par exemple électriquement, à une sortie du filtre passe-bas, une seconde entrée sur laquelle le deuxième signal *ref(t+τ)* ou le troisième signal *ref*

*(t-τ)* est destiné à être appliqué, et une sortie correspondant à la sortie de la boucle à verrouillage de retard et couplée, par exemple électriquement, à une entrée du premier comparateur de phases et à une entrée du second comparateur de phases.

La sortie de la ligne à retards commandée en tension de la boucle à verrouillage de retard des seconds moyens peut être directement reliée auxdites entrées du premier et du second comparateur de phases.

Le dispositif peut être apte à compenser n délais $\tau_1$ à $\tau_n$ subis par n premiers signaux $ref_1(t)$ à $ref_n(t)$ lors d'une propagation entre des premières et des secondes extrémités de n premières liaisons de transmission, n étant un nombre entier supérieur ou égal à 2, dans lequel les premiers moyens aptes à générer le deuxième signal $ref(t+\tau)$, τ étant égal à la moyenne des n délais $\tau_1$ à $\tau_n$, peuvent comporter :

- n comparateurs de phases, chacun étant apte à comparer une phase d'un des n premiers signaux $ref_1(t)$ à $ref_n(t)$ et une phase d'un signal obtenu à une première extrémité d'une deuxième liaison de transmission apte à retarder d'un délai sensiblement égal à τ un signal, tel qu'un signal électrique, propagé sur ladite deuxième liaison de transmission,
- n troisièmes liaisons de transmission, chacune étant apte à retarder d'un des délais $\tau_1$ à $\tau_n$ un signal, tel qu'un signal électrique, propagé sur ladite troisième liaison de transmission, comprenant une première extrémité reliée, par exemple électriquement, à une sortie d'un des n comparateurs de phases et une deuxième extrémité reliée, par exemple électriquement, à une entrée de moyens d'addition de signaux,
- un atténuateur du signal obtenu en sortie des moyens d'addition, de gain égal à environ 1/n,
- un filtre passe-bas apte à filtrer le signal obtenu en sortie des moyens d'addition ;
- un oscillateur commandé en tension dont une entrée est reliée, par exemple électriquement, à une sortie du filtre passe-bas et dont une sortie, correspondant à une sortie desdits premiers moyens, est couplée, par exemple électriquement, à une deuxième extrémité de la deuxième liaison de transmission,

ledit dispositif comportant en outre au moins une boucle à verrouillage de phase ou une boucle à verrouillage de retard comportant n entrées reliées, par exemple électriquement, aux deuxièmes extrémités des n premières liaisons de transmission et apte à délivrer le troisième signal $ref(t-τ)$.

En variante, le dispositif peut être apte à compenser n délais $\tau_1$ à $\tau_n$ subis par n premiers signaux $ref_1(t)$ à $ref_n(t)$ lors d'une propagation entre des premières et des secondes extrémités de n premières liaisons de transmission, n étant un nombre entier supérieur ou égal à 2, dans lequel les premiers moyens aptes à générer le deuxième signal $ref(t+τ)$, τ étant égal à la moyenne des n délais $\tau_1$ à $\tau_n$, peuvent comporter :

- n comparateurs de phases, chacun étant apte à comparer une phase d'un des n premiers signaux $ref_1(t)$ à $ref_n(t)$ et une phase d'un signal obtenu à une première extrémité d'une deuxième liaison de transmission apte à retarder d'un délai sensiblement égal à τ un signal propagé sur ladite deuxième liaison de transmission,
- n troisièmes liaisons de transmission, chacune étant apte à retarder d'un des délais $\tau_1$ à $\tau_n$ un signal propagé sur ladite troisième liaison de transmission, comprenant une première extrémité reliée à une sortie d'un des n comparateurs de phases et une deuxième extrémité reliée à une entrée de moyens d'addition de signaux,
- un atténuateur du signal obtenu en sortie des moyens d'addition, de gain égal à environ 1/n,
- un filtre passe-bas apte à filtrer le signal obtenu en sortie des moyens d'addition,
- une ligne à retards commandée en tension comprenant une première entrée reliée à une sortie du filtre passe-bas et une seconde entrée sur laquelle l'un des n premiers signaux $ref_1(t)$ à $ref_n(t)$ est destiné à être appliqué, et dont une sortie, correspondant à une sortie desdits premiers moyens, est couplée à une deuxième extrémité de la deuxième liaison de transmission,

ledit dispositif comportant en outre au moins une boucle à verrouillage de phase ou une boucle à verrouillage de retard comportant n entrées reliées aux deuxièmes extrémités des n premières liaisons de transmission et apte à délivrer le troisième signal $ref(t-τ)$.

En variante, les troisièmes liaisons de transmission peuvent être remplacées par une seule troisième liaison de transmission disposée entre l'atténuateur et le filtre passe-bas, ou entre le filtre passe-bas et l'oscillateur commandé en tension ou la ligne à retards commandée en tension.

Là encore, dans une première configuration, la sortie des moyens d'addition peut être reliée à l'entrée de l'atténuateur, et la sortie de l'atténuateur peut être reliée à l'entrée du filtre passe-bas. Dans une deuxième configuration, la sortie des moyens d'addition peut être reliée à l'entrée du filtre passe-bas. Dans ce cas, il est possible que le filtre passe-bas forme également, c'est-à-dire remplisse le rôle de, l'atténuateur.

L'invention concerne également un dispositif de distribution d'au moins un signal d'horloge $ref(t)$, comportant plusieurs liaisons de transmission sur lesquelles le signal d'horloge $ref(t)$ ou un signal, tel qu'un signal électrique, synchronisé avec le signal d'horloge *ref(t)* est destiné à être propagé, et une pluralité de dispositifs de compensation de délai, objets de la présente invention, couplés auxdites liaisons de transmission et aptes à compenser les délais de propagation des signaux sur lesdites liaisons de transmission. Un tel dispositif permet en outre de distribuer le ou les signaux d'horloge en basses fréquences.

Le dispositif peut comporter en outre au moins un dispositif de génération du signal d'horloge *ref(t)* .

Le dispositif peut comporter au moins une boucle à phase asservie apte à délivrer en sortie un signal d'horloge dont la phase est synchronisée par rapport à une moyenne de phases de plusieurs signaux délivrés par lesdits dispositifs de compensation de délai.

Le dispositif peut comporter en outre au moins deux dispositifs de compensation de délai couplés entre eux tels que :

- une sortie des premiers moyens aptes à générer un deuxième signal d'un premier des deux dispositifs de compensation de délai est couplée, par exemple électriquement, à une entrée des seconds moyens aptes à générer un quatrième signal d'un second des deux dispositifs de compensation de délai,
- une sortie des premiers moyens aptes à générer un deuxième signal du second des deux dispositifs de compensation de délai est couplée, par exemple électriquement, à une entrée des seconds moyens aptes à générer un quatrième signal du premier des deux dispositifs de compensation de délai.

La sortie des premiers moyens aptes à générer un deuxième signal d'un premier des deux dispositifs de compensation de délai peut être couplée, par exemple électriquement, à une entrée des seconds moyens aptes à générer un quatrième signal d'un second des deux dispositifs de compensation de délai par l'intermédiaire d'un ligne apte à retarder un signal d'un délai τ. De même, une sortie des premiers moyens aptes à générer un deuxième signal du second des deux dispositifs de compensation de délai peut être couplée, par exemple électriquement, à une entrée des seconds moyens aptes à générer un quatrième signal du premier des deux dispositifs de compensation de délai par l'intermédiaire d'un ligne apte à retarder un signal d'un délai τ.

L'invention concerne également un procédé de compensation d'un délai τ subi par un premier signal *ref(t)* lors d'une propagation entre une première et une seconde extrémité d'une première liaison de transmission, comportant au moins les étapes de :

- génération d'un deuxième signal *ref(t+τ)* correspondant au premier signal *ref(t)* dont la phase est avancée d'une durée égale au délai τ,
- génération, à partir d'un troisième signal *ref(t-τ)* obtenu à la seconde extrémité de la première liaison de transmission et correspondant au premier signal ref(t) dont la phase est retardée du délai τ, et à partir du deuxième signal *ref (t+τ),* d'un quatrième signal en phase avec le premier signal *ref(t).*

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un exemple de réseau distribué de PLL formant une architecture de distribution de signaux d'horloge,
- la figure 2 représente deux PLL voisines du réseau distribué de PLL représenté sur la figure 1,
- la figure 3 représente de manière schématique un délai de propagation subi par un signal lors d'une propagation de ce signal sur une liaison de transmission,
- la figure 4 représente schématiquement un dispositif de compensation de délai, objet de la présente invention, selon un mode de réalisation particulier,
- la figure 5 représente des premiers moyens aptes à générer un signal en avance de phase d'un dispositif de compensation de délai, objet de la présente invention, selon un mode de réalisation particulier,
- la figure 6 représente un schéma, dans le domaine de phase, de la synchronisation réalisée par les premiers moyens représentés sur la figure 5,
- les figures 7A et 7B représentent respectivement les phases et les signaux mis en jeu dans des premiers moyens aptes à générer un signal en avance de phase d'un dispositif de compensation de délai, objet de la présente invention, selon un mode de réalisation particulier,
- les figures 8 et 9 représentent des exemples de réalisation de seconds moyens aptes à générer un signal en phase avec le premier signal d'un dispositif de compensation de délai, objet de la présente invention, selon un mode de réalisation particulier,
- la figure 10 représente un schéma, dans le domaine de phase, de la synchronisation réalisée par les seconds moyens représentés sur la figure 8,

- les figures 11A et 11B représentent les signaux en entrée et sortie du dispositif de compensation de délai, objet de la présente invention, respectivement avant et après que la synchronisation de phases réalisée par le dispositif soit établie (régime établie après un régime transitoire),
- les figures 12 à 14 représentent des dispositifs de distribution de signaux d'horloge, également objets de la présente invention, selon différents modes de réalisation ;
- la figure 15 représente un dispositif de compensation de délai, objet de la présente invention, selon un autre mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

On décrit tout d'abord, en liaison avec la figure 3, le principe d'un délai, ou retard, subi par un signal, ici un signal électrique, lors d'une propagation de ce signal sur une liaison de transmission.

Une source 102 génère un signal périodique $ref(t)$ qui est envoyé sur une liaison de transmission 104, ici une ligne électrique, depuis une première extrémité 106 jusqu'à une seconde extrémité 108 de la liaison de transmission 104. La seconde extrémité 108 de la liaison de transmission 104 est reliée à une entrée d'un dispositif cible 110 destiné à recevoir le signal périodique $ref(t)$, par exemple pour se synchroniser. Le chemin de propagation formé par la liaison de transmission 104, depuis la sortie de la source 102, c'est-à-dire depuis sa première extrémité 106, jusqu'au dispositif cible 110, c'est-à-dire jusqu'à sa seconde extrémité 108, induit un délai, ou retard, $\tau$ correspondant au temps de propagation du signal depuis la première extrémité 106 jusqu'à la seconde extrémité 108, ce retard étant représenté symboliquement par un élément de retard 112 disposé sur la liaison de transmission 104. Ainsi, à un même instant, le signal reçu au niveau du dispositif cible 110 correspond en fait à un signal $ref(t-\tau)$, c'est-à-dire le signal $ref(t)$ retardé du délai $\tau$.

Ainsi, si le dispositif cible 110 est une PLL, celle-ci va alors se synchroniser par rapport au signal $ref(t-\tau)$ et non par rapport au signal $ref(t)$. Le signal obtenu en sortie de la PLL sera donc également retardé d'un délai égal à $\tau$ par rapport au signal émis par la source 102.

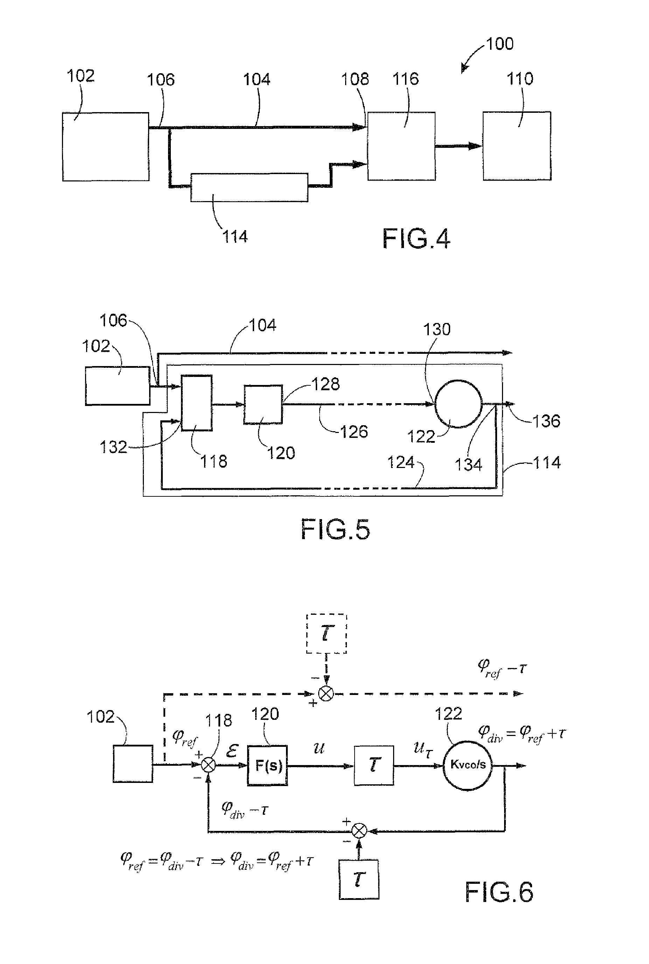

La figure 4 représente schématiquement un dispositif 100 de compensation du délai $\tau$ subi par le signal $ref(t)$, appelé premier signal, lors de sa propagation sur la liaison de transmission 104, appelée première liaison de transmission, entre la première extrémité 106 et la seconde extrémité 108 du fil 104, c'est-à-dire depuis la source 102 jusqu'au dispositif cible 110.

Le dispositif 100 comporte des premiers moyens 114 aptes à générer un deuxième signal $ref(t+\tau)$ correspondant au premier signal $ref(t)$ mais dont la phase est avancée du délai $\tau$. Pour cela, le premier signal $ref(t)$ est appliqué en entrée des premiers moyens 114. Les premiers moyens 114, dont la sortie se situe au niveau de la seconde extrémité 108 de la première liaison de transmission 104, délivre en sortie le deuxième signal $ref(t+\tau)$. La seconde extrémité 108 de la première liaison de transmission 104 est reliée électriquement à une première entrée de seconds moyens 116, une seconde entrée des seconds moyens 116 étant reliée électriquement à la sortie des premiers moyens 114. A partir d'un troisième signal $ref(t-\tau)$ obtenu à la deuxième extrémité 108 de la première liaison de transmission 104 et correspondant au premier signal $ref(t)$ dont la phase est retardée du délai $\tau$, et à partir du deuxième signal $ref(t+\tau)$, les seconds moyens 116 sont aptes à délivrer en sortie un quatrième signal en phase avec le premier signal électrique $ref(t)$, c'est-à-dire un signal synchronisé avec le premier signal $ref(t)$. Le signal électrique obtenu en sortie du dispositif 100 peut être similaire au premier signal électrique $ref(t)$, ou bien être synchronisé en phase mais avoir une fréquence différente de celle du premier signal $ref(t)$.

Des liaisons de transmission relient, l'entrée des premiers moyens 114 à la source 102 et à la première extrémité 106 de la première liaison de transmission 104, la sortie des premiers moyens 114 à une entrée des seconds moyens 116, et la sortie des seconds moyens 116 à l'entrée du dispositif cible 110. Bien qu'en théorie ces liaisons de transmission induisent elles aussi des délais de propagation, les longueurs de ces liaisons de transmission sont négligeables par rapport à la longueur de la première liaison de transmission 104. Ainsi, les délais de propagation subis par les signaux dans ces liaisons de transmission sont négligeables par rapport au délai $\tau$. De même, les délais de propagation subis par les signaux au sein des seconds moyens 116 sont également négligeables par rapport à $\tau$.

La figure 5 représente un exemple de réalisation des premiers moyens 114.

Dans cet exemple de réalisation, les premiers moyens comportent l'ensemble des éléments d'une PLL classique. Ainsi, les premiers moyens 114 comportent un comparateur, ou détecteur, de phases 118, un filtre passe-bas 120 et un oscillateur commandé en tension 122. Toutefois, contrairement à une PLL classique, les premiers moyens 114 comportent également deux liaisons de transmission 124 et 126, appelées respectivement deuxième et troisième liaison de transmission, aptes à retarder d'un délai sensiblement égal à τ un signal se propageant sur ces liaisons de transmission 124 et 126.

La sortie de la source 102, à laquelle est reliée électriquement la première extrémité 106 de la première liaison de transmission 104, est reliée électriquement à une entrée des premiers moyens 114 qui correspond à une première entrée du comparateur de phases 118. La sortie du comparateur de phases 118 est reliée électriquement à une entrée du filtre passe-bas 120. La sortie du filtre passe-bas 120 est reliée électriquement à une première extrémité 128 de la troisième liaison de transmission 126. Une seconde extrémité 130 de la troisième liaison de transmission 126 est reliée électriquement à une entrée de l'oscillateur commandé en tension 122. La sortie de l'oscillateur commandé en tension 122 correspond à une sortie 136 des premiers moyens 114. Enfin, une première extrémité 132 de la deuxième liaison de transmission 124 est reliée électriquement à une seconde entrée du comparateur de phases 118, et une seconde extrémité 134 de la deuxième liaison de transmission 124 est reliée électriquement à la sortie de l'oscillateur commandé en tension 122.

Hormis les délais τ induits par les liaisons de transmission 124 et 126, les délais de propagation subis par les signaux dans les autres liaisons de transmission des premiers moyens 114 sont négligeables par rapport à τ.

La deuxième liaison de transmission 124 permet de retarder la phase du signal délivré par l'oscillateur 122 d'un retard égal à τ. De même, la troisième liaison de transmission 126 permet de retarder la phase du signal délivré en sortie du filtre 120 d'un retard égal à τ.

Pour obtenir un même retard de propagation au sein des liaisons, ou lignes, électriques 104, 124 et 126, ces trois liaisons de transmission sont disposées les unes à côté des autres, ont une longueur sensiblement similaire et sont réalisées à partir d'un même matériau ou de matériaux différents engendrant des différences de délais négligeables. La proximité de ces trois liaisons de transmission permet également, en cas de perturbation faisant varier le retard de propagation, que cette variation soit identique sur les trois liaisons de transmission.

Comme dans une PLL classique, les éléments des premiers moyens 114 forment une structure de synchronisation. Soit *div(t)* le signal délivré par l'oscillateur commandé en tension 122, correspondant au signal délivré en sortie des premiers moyens 114. Compte tenu du délai τ induit par la deuxième liaison de transmission 124, le signal appliqué sur la seconde entrée du comparateur de phases 118 correspond au signal *div(t-τ)*. Les premiers moyens 114 vont donc asservir la phase du signal *div(t-τ)* par rapport à la phase du signal *ref(t)*. Après une période transitoire, la boucle de rétroaction formée par les premiers moyens 114 va donc égaliser les deux signaux appliqués en entrée du comparateur de phases 118 tel que :

$$ref(t) = div(t-\tau)$$

Cela revient à dire que le signal div(t) à la sortie de l'oscillateur 122 correspond au signal *ref(t+τ)*.

Cette avance de phase est obtenue en raison de la périodicité du signal ref(t) :

$$ref(t) = ref(t \pm y.T)$$

avec T : période du signal
y . nombre entier supérieur ou égal à 1.

Or, une avance de phase peut être toujours interprétée comme un retard de phase d'une valeur τ' correspondant :

$$ref(t + \tau) = ref(t + nT - (nT - \tau)) = ref(t - (nT - \tau)) = ref(t - \tau')$$

où $n \in \mathbb{Z}$ est un nombre entier suffisamment grand pour que $\tau' = nT - \tau \geq 0$.

La figure 6 représente un schéma, dans le domaine de phase, de la synchronisation réalisée par les premiers moyens 114 après stabilisation du système. Dans ce schéma, seules les phases des signaux se propageant dans les premiers moyens 114 sont donc prises en compte.

La phase du signal obtenu en sortie de la source 102 correspond à $\varphi_{ref}$. Du point de vue des phases, l'opération réalisée par le comparateur de phases 118 correspond à une soustraction de la phase du signal provenant de la deuxième liaison de transmission 124, à savoir $\varphi_{div} - \tau$, à la phase du signal appliqué en entrée des premiers moyens 114. Ainsi, le signal de sortie $\varepsilon$ du comparateur de phases 118 est tel que :

$$\varepsilon = \varphi_{ref} - \left( \varphi_{div} - \tau \right)$$

Le filtre passe-bas 120 est remplacé, dans le domaine de Laplace, par sa fonction de transfert *F(s),* tel que :

$$u(s) = \varepsilon(s).F(s)$$

Le retard engendré par la troisième liaison de transmission 126 (identique à la première et la deuxième liaison de transmission 104 et 124) correspond à un retard pur $\tau$ tel que :

$$u_\tau(s) = u(s).e^{-\tau s}$$

Enfin, l'oscillateur commandé 122 est remplacé, dans le domaine de Laplace, par un intégrateur de type $K_{vco}/s$.
Après une période transitoire, le signal $\varepsilon$ va tendre vers 0, ce qui revient à écrire :

$$\varphi_{ref} = \varphi_{div} - \tau \quad \text{et donc}$$

$$\varphi_{div} = \varphi_{ref} + \tau$$

Compte tenu des retards introduits artificiellement dans la boucle fermée par les deuxième et troisième liaisons de transmission 124 et 126, la stabilité de cette boucle peut devenir critique. Le retard introduit par la deuxième liaison de transmission 124 entre l'oscillateur commandé en tension 122 et le comparateur de phases 118, dans le domaine de phase, est une simple constante additionnée à la phase du signal et donc ne joue pas sur la stabilité du système linéaire ainsi obtenu mais joue sur son point de fonctionnement. Par contre, le retard $\tau$ introduit par la troisième liaison de transmission 126 entre le filtre passe-bas 120 et l'oscillateur commandé en tension 122, est un retard pur ($u_\tau(s) = u(s).e^{-\tau s}$ dans le domaine de Laplace) car le signal de commande u délivré en sortie du filtre passe-bas 120 est un signal non périodique. Ainsi, le filtre passe-bas 120 pourra être réalisé tel qu'il garantisse à la fois une bonne stabilité de la boucle et une erreur statique nulle (par exemple de Type II PLL, filtre réalisant l'opération d'intégration pure 1/s). Un tel filtre peut présenter une réponse fréquentielle correspondant à une droite présentant une pente de -20 dB/dec en basses fréquences. En analogique, ce type de filtre peut être réalisé par une capacité intégrant le signal en entrée. Dans le domaine discret, un tel filtre peut être réalisé par un accumulateur dont la sortie est ramenée à son entrée avec un signe « + ».
Dans l'exemple décrit en liaison avec les figures 5 et 6, le filtre passe-bas 120 est disposé entre le comparateur de phases 118 et la troisième liaison de transmission 126. Dans une autre configuration, il est possible que la troisième liaison de transmission 126 soit disposée entre le comparateur de phases 118 et le filtre passe-bas 120. Le signal obtenu en sortie des premiers moyens 114 est dans ce cas similaire à celui précédemment décrit pour le cas où le filtre passe-bas 120 est disposé entre le comparateur de phases 118 et la troisième liaison de transmission 126. Il est également possible que l'oscillateur commandé en tension 122 soit disposé entre le filtre passe-bas 120 et la troisième liaison de transmission 126 qui est alors reliée à la deuxième liaison de transmission 124.
Dans une autre variante de réalisation des premiers moyens 114, l'oscillateur commandé en tension 122 peut être remplacé par une ligne à retards commandée en tension (VCDL), formée par exemple de plusieurs cellules à retard reliées en série les unes aux autres. Dans cette configuration, la ligne à retards peut être disposée entre le filtre passe-bas 120 et la troisième ligne de transmission 126 et reçoit en entrée le signal délivré en sortie du filtre 120 ainsi que le signal délivré par la source 102, c'est-à-dire *ref(t).* Selon cette variante, étant donné que le comparateur de phases reçoit en entrée le signal *ref(t)* et un signal retardé de 2$\tau$ (un premier retard $\tau$ induit par la troisième liaison de transmission 126 et un deuxième retard $\tau$ induit par la deuxième liaison de transmission 124), la ligne à retards délivre donc en sortie le signal *ref(t)* en avance de 2τ, c'est-à-dire *ref(t+2τ)*. Le signal obtenu en sortie des premiers moyens 114 correspond donc à ce signal *ref(t+2τ)* qui est retardé de τ par la troisième liaison de transmission 126, c'est-à-dire *ref(t+τ)*. Lorsque l'oscillateur commandé en tension 122 est remplacé par la ligne à retards commandée en tension, il est également possible que la troisième liaison de transmission 126 ne soit pas disposée en aval de la ligne à retards, mais entre la ligne à retards et le filtre passe-bas 120, ou encore entre le filtre passe-bas 120 et le comparateur de phases 118.

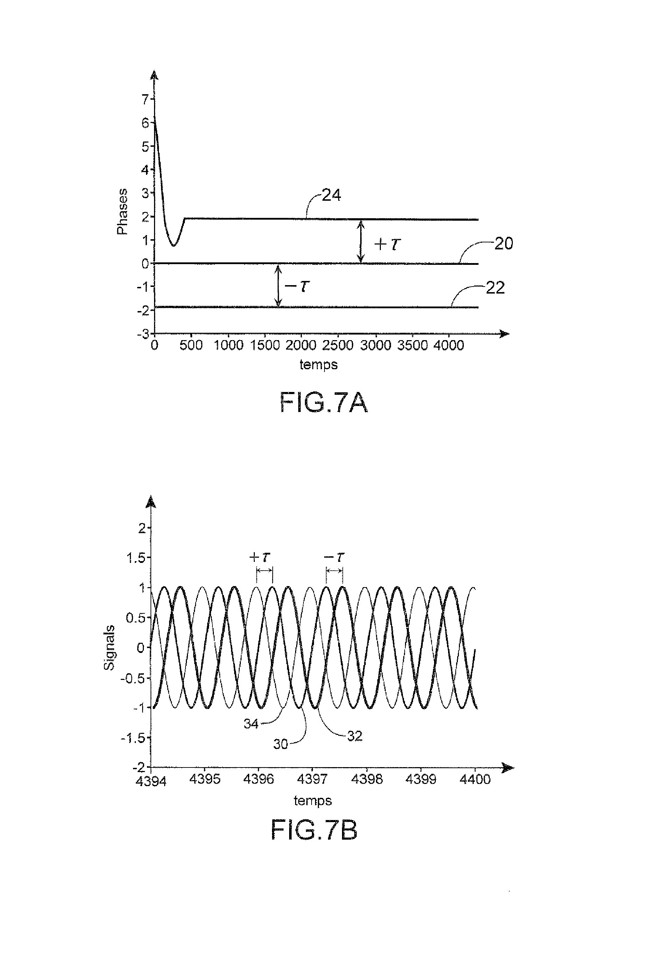

Les phases relatives (c'est-à-dire $\varphi_{signal}\text{-}\varphi_{\text{-}ref}$) des signaux précédemment décrits sont représentées sur la figure 7A, en fonction du temps. La droite référencée 20 correspond à la phase $\varphi_{ref}$, c'est-à-dire la phase du signal délivré par la source 102 en entrée des premiers moyens 114. La droite référencée 22 correspond à la phase $\varphi_{ref}$ - τ, c'est-à-dire la phase du signal obtenu à la seconde extrémité 108 de la première liaison de transmission 104. Enfin, la courbe référencée 24 correspond à la phase du signal obtenu en sortie des premiers moyens 114. Après une courte période transitoire, on voit que cette phase se stabilise et présente ensuite un écart constant égal à +τ par rapport à la phase $\varphi_{ref}$ du signal appliqué en entrée des premiers moyens 114.

Les signaux précédemment décrits sont représentés sur la figure 7B. Les courbes 30, 32 et 34 correspondent respectivement aux signaux *ref(t)*, *ref(t-τ)* et *div(t) = ref(t+τ)* obtenus après stabilisation de la synchronisation réalisée par les premiers moyens 114. On voit bien sur cette figure que le signal *ref(t-τ)* présente un retard égal à τ par rapport au signal *ref(t)*, et qu'au contraire le signal *div(t)* délivré par les premiers moyens 114 présente une avance de phase égale à τ par rapport au signal *ref(t)*.

A partir des signaux 32 et 34, on utilise des moyens 116 permettant de réaliser une opération d'addition de phases de ces deux signaux.

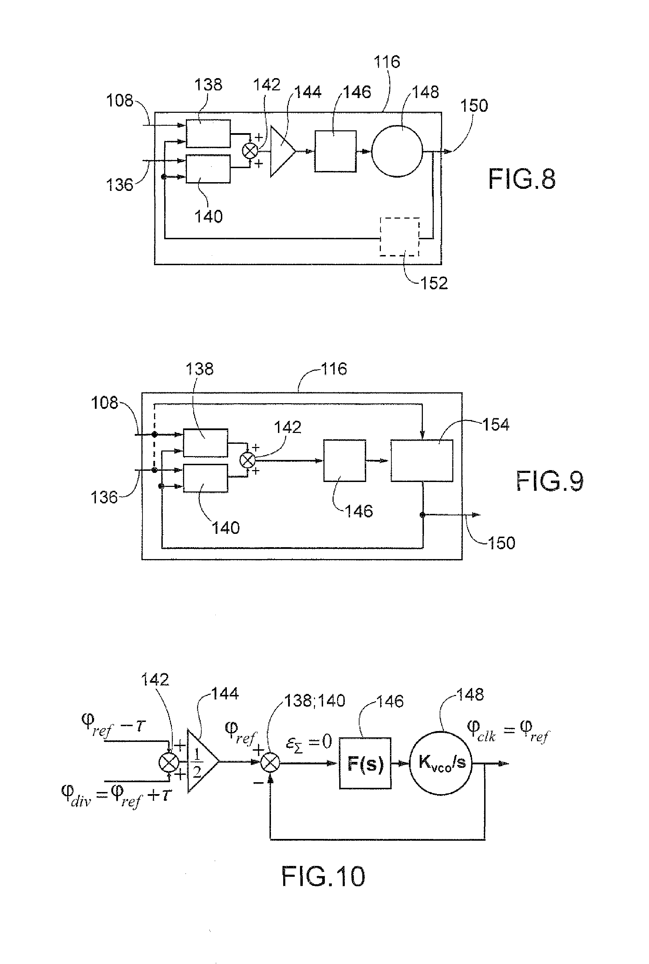

La figure 8 représente un premier exemple de réalisation des seconds moyens 116 permettant de générer, à partir du signal électrique *ref(t-τ)* obtenu à la deuxième extrémité 108 de la première liaison de transmission 102 et du signal électrique *ref(t+τ)* obtenu en sortie des premiers moyens 114, un signal électrique similaire au premier signal *ref(t)*.

Dans ce premier exemple de réalisation, les seconds moyens 116 forment une PLL à deux entrées. La seconde extrémité 108 de la première liaison de transmission 104 est reliée électriquement à une première des deux entrées correspondant à une première entrée d'un premier comparateur de phases 138, la sortie 136 des premiers moyens 114 étant reliée électriquement à une seconde des deux entrées de la PLL correspondant à une première entrée d'un second comparateur de phases 140.

Les sorties des deux comparateurs de phases 138 et 140 sont reliées électriquement à deux entrées d'un additionneur 142. La sortie de l'additionneur 142 est reliée électriquement à une entrée d'un atténuateur 144 de gain égal à 0,5. Enfin, la sortie de l'atténuateur 144 est reliée à une entrée d'un filtre passe-bas 146 qui est lui-même relié à un oscillateur commandé en tension 148. La sortie de l'oscillateur commandé en tension 148 correspond à une sortie 150 des seconds moyens 116 et est envoyée sur les secondes entrées des comparateurs de phases 138 et 140 afin de former la boucle de rétroaction de la PLL formée par les seconds moyens 116.

La PLL formée par les seconds moyens 116 va ainsi générer sur la sortie 150 un signal qui, après une période transitoire, va se situer, temporellement, entre les deux signaux appliqués sur les deux entrées des seconds moyens 116, et qui correspondra donc au signal *ref(t)*.

Dans une variante de réalisation, les seconds moyens 116 peuvent comporter un diviseur de fréquence 152 (représenté en pointillés sur la figure 8) interposé dans la boucle de rétroaction de la PLL, c'est-à-dire entre la sortie de l'oscillateur commandé en tension 148 et les secondes entrées des comparateurs des phases 138 et 140. Ce diviseur de fréquence 152 peut présenter un facteur de division égal à *N, N* étant supérieur à 1, permettant de réduire d'un facteur *N* le signal envoyé en entrée des comparateurs de phases 138 et 140, et donc d'augmenter d'un facteur *N* la fréquence du signal délivré par les seconds moyens 116, qui correspond également au signal délivré en sortie par le dispositif 100, par rapport au signal d'origine *ref(t)*. Le dispositif 100 peut ainsi générer un signal d'horloge en haute fréquence et synchronisé par rapport au signal d'horloge *ref(t)* qui est en basse fréquence. L'absence du diviseur de fréquence 152 dans la PLL formée par les seconds moyens 116 est analogue au cas où un diviseur de fréquence présentant un facteur de division *N=1* serait interposé dans la boucle de rétroaction de la PLL.

Dans une variante, et selon les besoins de l'application, on pourrait envisager d'avoir un facteur de division *N* tel que 0 < *N* < 1. Un tel cas correspondrait à remplacer le diviseur de fréquence 152 par un multiplicateur de fréquence qui permettrait de réduire la fréquence du signal délivré sur la sortie 150.

Un autre exemple de réalisation des seconds moyens 116 est représenté sur la figure 9. Par rapport à l'exemple de la figure 8 dans lequel les seconds moyens 116 forment une boucle à verrouillage de phase (PLL), les seconds moyens 116 représentés sur la figure 9 forment une boucle à verrouillage de retard (DLL). Par rapport à la PLL représentée sur la figure 8, l'oscillateur commandé en tension est ici remplacé par une ligne à retards commandée en tension 154 (VCDL), formée par exemple de plusieurs cellules à retard reliées en série les unes aux autres. Etant donné que les deux signaux *ref(t-τ)* et *ref(t+τ)* à l'entrée de la DLL ont la même fréquence après une période transitoire du système, l'un ou l'autre de ces signaux peut être appliqué en entrée de la ligne à retards 154 afin de retarder ou accélérer ce signal par une commande du filtre, en le positionnant, d'un point de vue temporel, au milieu, entre les signaux provenant des extrémités 108 et 136 et appliqués en entrée de la DLL.

De plus, dans ces seconds moyens 116, l'atténuation de gain égal à environ 0,5 du signal délivré en sortie des moyens d'addition 142 est réalisée ici directement par le filtre passe-bas 146 dont le gain statique est tel que le filtre réalise cette atténuation. Le filtre passe-bas 146 forme donc ici l'atténuateur du signal obtenu en sortie des moyens d'addition 142, de gain égal à environ 0,5. Cette variante dans laquelle le filtre passe-bas forme également l'atténuateur peut également s'appliquer à l'exemple précédemment décrit en liaison avec la figure 8.

La figure 10 représente un schéma, dans le domaine de phase, de la synchronisation réalisée par les seconds moyens 116 après stabilisation du système. Dans ce schéma, seules les phases des signaux se propageant dans les seconds moyens 116 sont donc prises en compte. Sur ce schéma, on considère que les seconds moyens 116 ne comportent pas le diviseur de fréquence 152. De plus, pour des raisons de clarté, l'additionneur 142 et l'atténuateur 144 sont disposés en amont des comparateurs de phases 138 et 140.

On voit sur cette figure qu'à partir des signaux de phases $\varphi_{ref}$ - $\tau$ et $\varphi_{div}$ = $\varphi_{ref}$ + $\tau$, on obtient un signal électrique de phase égale à $\varphi_{ref}$. En appelant *clk(t)* le signal obtenu en sortie des seconds moyens 116, on voit qu'à la fin d'une période transitoire, le signal *clk(t)* généré par la PLL formée par les seconds moyens 116 va être synchrone avec le signal *ref(t)* tel que :

$$clk(t) = ref\left(\frac{2t - \tau + \tau}{2}\right) = ref(t) \Leftrightarrow \varphi_{clk} = \frac{2\varphi_{ref} - \tau + \tau}{2} = \varphi_{ref}$$

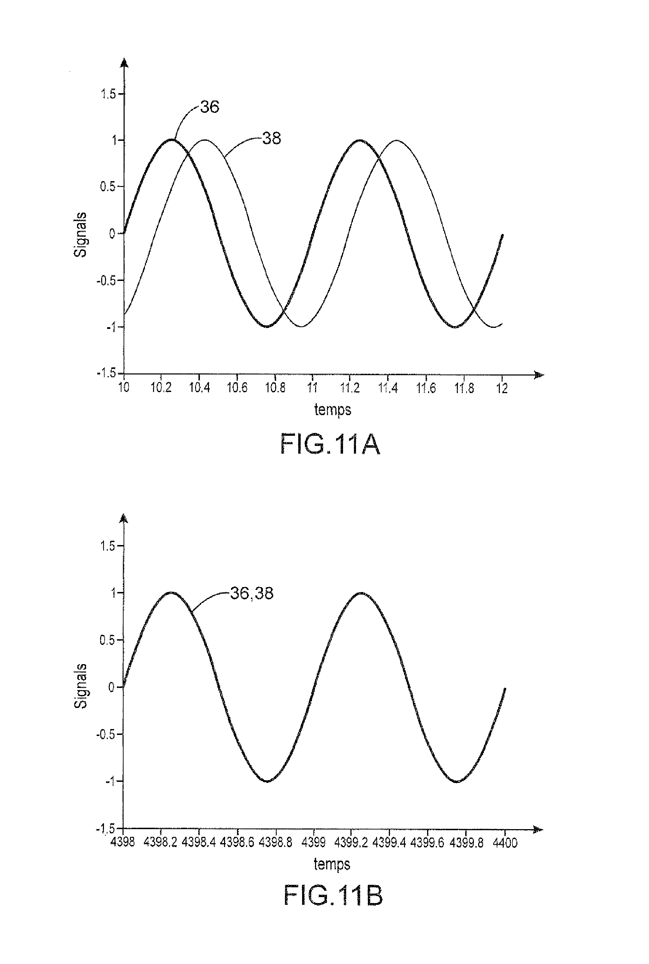

Les courbes 36 et 38 représentées sur la figure 11A correspondent respectivement aux signaux *ref(t)* et *clk(t)* lorsque le dispositif 100 n'est pas encore stabilisé. On voit sur cette figure que les deux signaux présentent un écart de phase. Une fois que la synchronisation réalisée par le dispositif 100 est établie, ces deux signaux sont alors en phase et, lorsque les seconds moyens 116 ne comportent pas le diviseur de fréquence 152, se superposent comme représentés sur la figure 11B.

Les premiers et seconds moyens 114 et 116 du dispositif de compensation de délai 100 peuvent être réalisés à partir d'éléments analogiques ou numériques, en fonction du type de signaux à synchroniser et de l'application envisagée. Les PLL numériques (ADPLL) comportent des comparateurs de phases numériques (comparateur de type Bang-bang, convertisseur de type « Time to Digital convertor », XOR, ...), des filtres numériques (à réponse impulsionnelle finie ou infinie) ainsi que des oscillateurs commandés numériques. Les PLL analogiques comportent des comparateurs de phases analogiques (par exemple à pompe de charge), des filtres analogiques (réalisés par des capacités, des éléments à inductance et des résistances) et des oscillateurs commandés en tension.

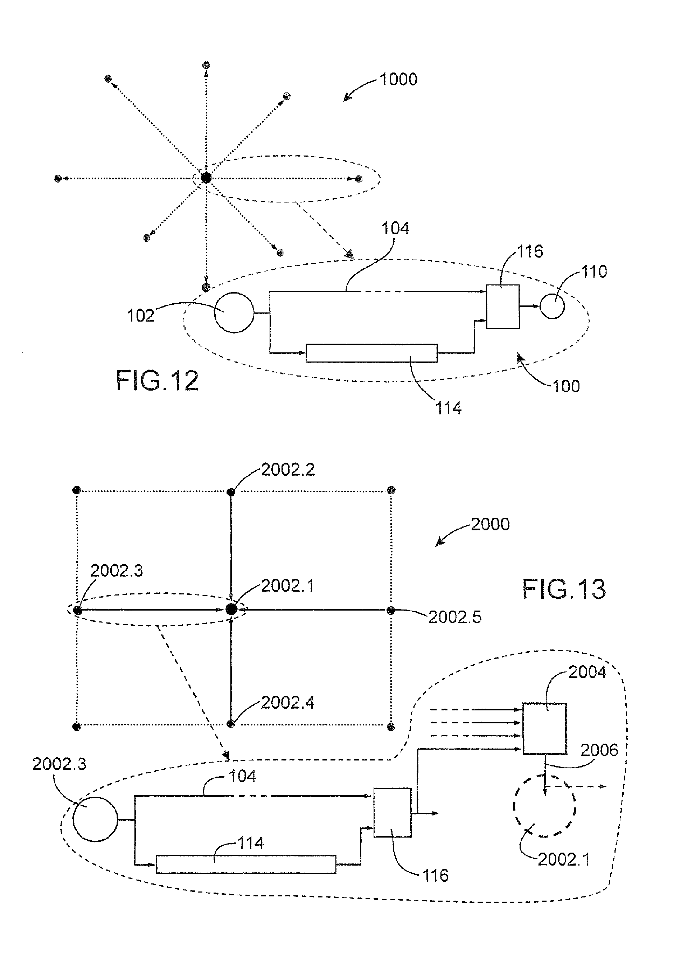

Le dispositif de compensation de délai 100 peut être appliqué par exemple à chaque branche d'un arbre de distribution d'horloge. Un exemple de réalisation d'un tel dispositif de distribution de signaux d'horloge 1000 est représenté sur la figure 12. Le dispositif 1000 comporte un dispositif de génération du signal d'horloge *ref(t)*, formant la source 102, ce signal étant destiné à être propagé dans toutes les branches du dispositif 1000. Chaque branche comporte une liaison de transmission 104 reliée à la source 102 qui est donc commune pour l'ensemble des branches du dispositif 1000. D'une branche à l'autre, les longueurs des liaisons de transmission 104 peuvent être différentes ou non. Un dispositif de compensation de délai 100 est couplé à chaque branche du dispositif 1000, c'est-à-dire à chaque liaison de transmission 104. Les liaisons de transmission de chaque dispositif de compensation de délai 100 sont dimensionnées en fonction de la liaison de transmission 104 à laquelle est couplé le dispositif 100. Avec un tel arbre de distribution 1000, chaque dispositif cible 110 se trouvant aux extrémités des branches de l'arbre 1000 et destiné à recevoir le signal d'horloge *ref(t)* reçoit un signal *clk(t)* délivré par le dispositif 100 de compensation de délai qui est en phase, synchrone et non retardé par rapport au signal d'horloge *ref(t)* malgré les différents retards engendrés par les liaisons de transmission 104.

Le signal délivré par le dispositif de compensation de délai 100 peut également être propagé à son tour dans différentes branches couplées à des dispositifs de compensation de délai similaires au dispositif 100, le signal délivré par le dispositif 100 servant dans ce cas de signal d'horloge de source.

Le dispositif de compensation de délai 100 peut également être utilisé dans un arbre de distribution de signaux d'horloge actif, comportant un réseau de PLL tel que précédemment décrit en liaison avec la figure 1. Un exemple d'un tel dispositif de distribution de signaux d'horloge 2000 est représenté sur la figure 13. Le dispositif 2000 comporte une pluralité de noeuds 2002 reliés électriquement entre eux sous la forme d'une grille. Ainsi, chaque noeud 2002 reçoit en entrée plusieurs signaux d'horloge provenant des noeuds voisins et est destiné à générer un signal d'horloge synchronisé par rapport aux signaux d'horloges reçus. Chaque liaison de transmission entre deux noeuds voisins 2002 comporte une première liaison de transmission 104 couplée à un dispositif de compensation de délai de propagation 100 permettant de compenser le délai de propagation entre ces deux noeuds voisins 2002. Sur l'exemple de la figure 13, le noeud 2002.1 se trouvant au centre de la grille est relié électriquement à 4 noeuds voisins 2002.2 à 2002.5 et reçoit donc en entrée 4 signaux d'horloge. Ces 4 signaux d'horloge correspondent aux signaux délivrés par les 4 dispositifs de compensation de délai 100 couplés aux quatre liaisons de transmission 104 reliées à ce noeud central 2002.1 et sont ensuite envoyés en entrée d'une boucle à phase asservie 2004. Cette boucle à phase asservie 2004 permet de générer sur une sortie 2006, au niveau du noeud 2002.1, un signal d'horloge dont la phase est synchronisée par rapport à une moyenne des phases des signaux d'horloge délivrés par les 4 dispositifs de compensation de délai 100 reliés au noeud 2002.1.

Par rapport au dispositif 1000 précédemment décrit, le dispositif 2000 offre une meilleure robustesse notamment vis-à-vis d'une éventuelle défaillance d'un ou plusieurs noeuds du dispositif lors de son fonctionnement. Par exemple, si le noeud 2002.2 ne délivre plus de signal d'horloge, le noeud 2002.1 peut tout de même se synchroniser par rapport aux trois noeuds restants 2002.3 à 2002.5.

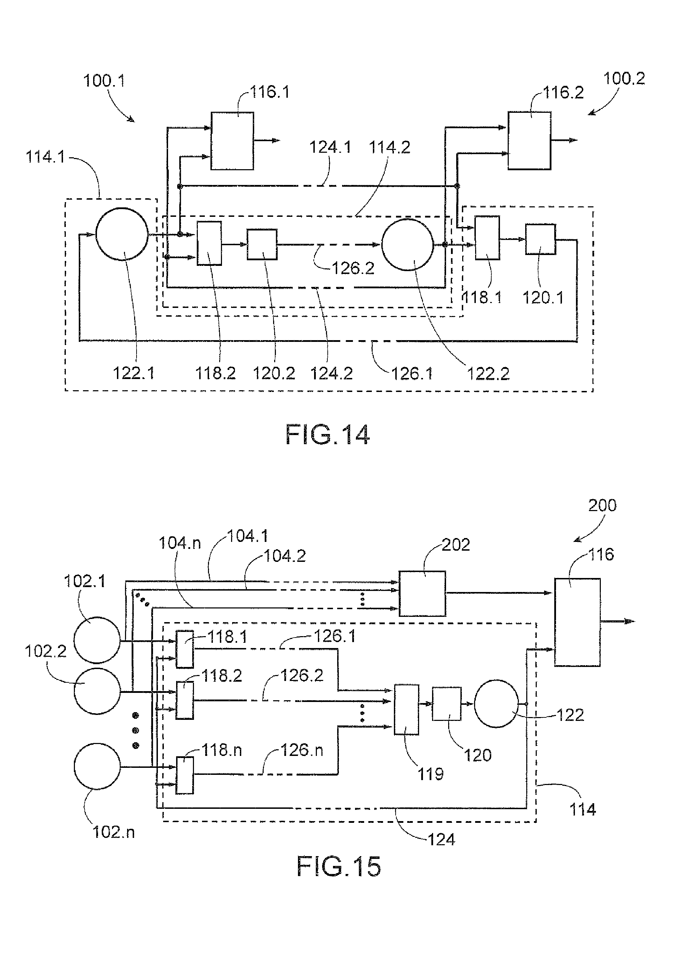

Dans une variante de réalisation du dispositif de distribution de signaux d'horloge 2000, il est possible que deux noeuds voisins 2002 reliés électriquement entre eux se servent mutuellement des signaux d'horloge délivrés par l'un et l'autre pour se synchroniser. Dans ce cas, la liaison de transmission entre les deux noeuds peut être réalisée par deux dispositifs de compensation de délai 100.1 et 100.2 sans nécessiter la présence d'une liaison de transmission 104 distincte de ces deux dispositifs. La figure 14 représente deux noeuds voisins réalisés selon cette configuration.

Les éléments des deux dispositifs de compensation de délais 100.1 et 100.2 formant les premiers moyens 114.1 et 114.2 et les seconds moyens 116.1 et 116.2 de ces deux dispositifs 100.1 et 100.2 sont par exemple similaires à ceux précédemment décrits pour le dispositif de compensation de délai 100 en liaison avec les figures 4, 5 et 8 ou 9.

En outre, une sortie des premiers moyens 114.1 du premier dispositif de compensation de délai 100.1 est couplée électriquement à une entrée des seconds moyens 116.2 du second dispositif de compensation de délai 100.2. Une sortie des premiers moyens 114.2 du second dispositif de compensation de délai 100.2 est couplée électriquement à une entrée des seconds moyens 116.1 du premier dispositif de compensation de délai 100.1. Dans cette configuration, les secondes liaisons de transmission 124.1 et 124.2 permettent de transmettre d'un noeud à l'autre les signaux retardés de $\tau$ correspondant au signal $ref(t-\tau)$ précédemment décrit. Le signal délivré par l'oscillateur commandé en tension 122.1 des premiers moyens 114.1 du premier dispositif de compensation de délai 100.1 est donc considéré par les seconds moyens 116.2 du second dispositif de compensation de délai 100.2 comme le signal délivré par la source. De même, le signal délivré par l'oscillateur commandé en tension 122.2 des premiers moyens 114.2 du second dispositif de compensation de délai 100.2 est donc considéré par les seconds moyens 116.1 du premier dispositif de compensation de délai 100.1 comme le signal délivré par la source.

Cette configuration permet d'obtenir en sortie des seconds moyens 116.1 et 116.2 des signaux d'horloge synchronisés en phase, et donc sans déphasage l'un par rapport à l'autre.

De plus, il est également possible que l'oscillateur commandé en tension 122.1 soit disposé entre le filtre passe-bas 120.1 et la troisième liaison de transmission 126.1, et/ou que l'oscillateur commandé en tension 122.2 soit disposé entre le filtre passe-bas 120.2 et la troisième liaison de transmission 126.2. Les oscillateurs commandés en tension 122.1 et 122.2 peuvent également être disposés, l'un et/ou l'autre, entre le comparateur et le filtre passe-bas des premiers moyens correspondants.

En variante, les oscillateurs commandés en tension 122.1 et 122.2 (l'un et/ou l'autre) peuvent être remplacés par des lignes à retards commandées en tension. Dans ce cas, chacune des lignes à retards est disposée entre le filtre passe-bas et la troisième liaison de transmission des premiers moyens 114 correspondants, ou bien en aval des troisièmes lignes de transmission comme précédemment décrit.

La figure 15 représente un exemple de réalisation d'un dispositif de compensation de délai 200 destiné à être utilisé dans un réseau de PLL à 2 ou 3 dimensions et destiné à générer un signal d'horloge synchronisé en phase avec n signaux d'horloge $ref_1(t)$ à $ref_n(t)$ délivrés par n sources 102.1 à 102.n, et donc apte à compenser n délais $\tau_1$ à $\tau_n$ subis par les n signaux $ref_1(t)$ à $ref_n(t)$ lors d'une propagation sur n premières liaisons de transmission 104.1 à 104.n, avec n nombre entier supérieur ou égal à 2.

Le dispositif de compensation de délai 200 comporte des premiers moyens 114 aptes à générer un signal électrique $ref(t+\tau)$, $\tau$ étant ici considéré comme la moyenne des n délais $\tau_1$ à $\tau_n$.

Ces premiers moyens 114 comportent n comparateurs de phases 118.1 à 118.n, chacun étant apte à comparer une phase d'un des n premiers signaux électriques $ref_1(t)$ à $ref_n(t)$ et une phase d'un signal électrique obtenu délivré en sortie de ces premiers moyens et transmis à travers une deuxième liaison de transmission 124 apte à retarder d'un délai sensiblement égal à $\tau$ un signal électrique propagé sur cette deuxième liaison de transmission. Les signaux délivrés par les n comparateurs de phases 118.1 - 118.n sont envoyés à travers $n$ troisièmes liaisons de transmission 126.1 - 126.n, chacune étant apte à retarder d'un délai $\tau_1$ à $\tau_n$ correspondant un signal électrique propagé sur ladite troisième liaison de transmission, en entrée de moyens 119 formant un additionneur couplé à un atténuateur de gain égal à 1/n. Le résultat délivré par l'atténuateur est envoyé à travers un filtre passe-bas 120 puis en entrée d'un oscillateur commandé en tension délivrant un signal $ref(t+\tau)$ en sortie des premiers moyens 114.

Parallèlement à cela, les n signaux $ref_1(t)$ à $ref_n(t)$ propagés à travers les n premières liaisons de transmission 104.1 à 104.n sont envoyés en entrée d'une boucle à verrouillage de phase 202 délivrant un signal $ref(t-\tau)$. Comme

pour le dispositif de compensation de délai 100 précédemment décrit, les signaux *ref(t+τ)* et *ref(t-τ)* sont envoyés en entrées de seconds moyens 116, par exemple similaires à ceux précédemment décrits en liaison avec les figures 8 et 9, c'est-à-dire comportant une boucle à verrouillage de phase ou une boucle à verrouillage de retard, afin de délivrer en sortie un signal *ref(t)* synchrone par rapport à une signal de référence moyen dont la phase correspond à la moyenne des phases des *n* signaux $ref_1(t)$ à $ref_n(t)$.

Comme pour le dispositif de compensation de délai 100, un diviseur de fréquence peut être inséré dans la boucle de retour des deuxièmes moyens 116, afin que le signal électrique délivré par le dispositif 200 présente une fréquence différente, par exemple supérieure, à celle du signal de référence moyen dont la phase correspond à la moyenne des phases des n signaux $ref_1(t)$ à $ref_n(t)$. De plus, comme précédemment décrit, l'oscillateur commandé en tension peut être remplacé par une ligne à retards commandée en tension. Les troisièmes liaisons de transmission peuvent également être remplacées par une seule troisième liaison de transmission interposée entre les moyens 119 et le filtre passe-bas 120, ou entre le filtre 120 et l'oscillateur commandé 122 (ou la ligne à retards commandée en tension).

## Revendications

1. Dispositif (100, 200) de compensation d'un délai τ subi par un premier signal *ref(t)* périodique lors d'une propagation entre une première (106) et une seconde extrémité (108) d'une première liaison de transmission (104, 124.1, 124.2), comportant au moins :

   - des premiers moyens (114) aptes à générer un deuxième signal *ref(t+τ)* correspondant au premier signal ref (t) dont la phase est avancée d'une durée égale au délai τ,
   - des seconds moyens (116) aptes à générer, à partir d'un troisième signal *ref(t-τ)* obtenu à la seconde extrémité de la première liaison de transmission (104, 124.1, 124.2) et correspondant au premier signal *ref(t)* dont la phase est retardée du délai τ, et à partir du deuxième signal *ref(t+τ)*, un quatrième signal en phase avec le premier signal *ref(t)*.

2. Dispositif (100, 200) selon la revendication 1, dans lequel les premiers moyens (114) aptes à générer le deuxième signal *ref(t+τ)* comportent au moins :

   - un comparateur de phases (118) apte à comparer une phase du premier signal *ref(t)* et une phase d'un signal obtenu à une première extrémité (132) d'une deuxième liaison de transmission (124) apte à retarder d'un délai sensiblement égal à τ un signal propagé sur ladite deuxième liaison de transmission (124),
   - un oscillateur commandé en tension (122) dont une sortie, correspondant à une sortie (136) desdits premiers moyens, est reliée à une seconde extrémité (134) de la deuxième liaison de transmission (124),
   - une troisième liaison de transmission (126) apte à retarder d'un délai sensiblement égal à τ n signal propagé sur ladite troisième liaison de transmission (126), comprenant une première extrémité (128) couplée à une sortie du comparateur de phases (118) et une seconde extrémité (130) couplée à une entrée de l'oscillateur commandé en tension (122).

3. Dispositif (100, 200) selon la revendication 2, dans lequel les premiers moyens (114) aptes à générer le deuxième signal *ref(t+τ)* comportent en outre un filtre passe-bas (120), la première extrémité (128) de la troisième liaison de transmission (126) étant couplée à la sortie du comparateur de phases (118) au moins par l'intermédiaire dudit filtre passe-bas (120) ou la seconde extrémité (130) de la troisième liaison de transmission (126) étant couplée à l'entrée de l'oscillateur commandé en tension (122) au moins par l'intermédiaire dudit filtre passe-bas (120).

4. Dispositif (100, 200) selon la revendication 1, dans lequel les premiers moyens (114) aptes à générer le deuxième signal *ref(t+τ)* comportent au moins :

   - un comparateur de phases (118) apte à comparer une phase du premier signal *ref(t)* et une phase d'un signal obtenu à une première extrémité (132) d'une deuxième liaison de transmission (124) apte à retarder d'un délai sensiblement égal à $_T$ un signal propagé sur ladite deuxième liaison de transmission (124),
   - un filtre passe-bas (120) dont une entrée est reliée à une sortie du comparateur de phases (118),
   - un oscillateur commandé en tension (122) dont une entrée est reliée à une sortie du filtre passe-bas (120),
   - une troisième liaison de transmission (126) apte à retarder d'un délai sensiblement égal à τ un signal propagé sur ladite troisième liaison de transmission (126), comprenant une première extrémité (128) reliée à une sortie de l'oscillateur commandé en tension (122) et une seconde extrémité (130), correspondant à une sortie (136) desdits premiers moyens, reliée à une seconde extrémité (134) de la deuxième liaison de transmission (124).

**5.** Dispositif (100, 200) selon la revendication 1, dans lequel les premiers moyens (114) aptes à générer le deuxième signal *ref(t+τ)* comportent au moins :

- un comparateur de phases (118) apte à comparer une phase du premier signal *ref(t)* et une phase d'un signal obtenu à une première extrémité (132) d'une deuxième liaison de transmission (124) apte à retarder d'un délai sensiblement égal à τ un signal propagé sur ladite deuxième liaison de transmission (124),
- un filtre passe-bas (120) dont une entrée est couplée à la sortie du comparateur de phases (118),
- une ligne à retards commandée en tension comprenant une première entrée couplée à une sortie du filtre passe-bas (120) et une seconde entrée sur laquelle le premier signal *ref(t)* est destiné à être appliqué,
- une troisième liaison de transmission (126) apte à retarder d'un délai sensiblement égal à τ un signal propagé sur ladite troisième liaison de transmission (126), interposée entre le comparateur de phases (118) et le filtre passe-bas (120), ou entre le filtre passe-bas (120) et la ligne à retards commandée en tension, ou entre la ligne à retards commandée en tension et la deuxième liaison de transmission.

**6.** Dispositif (100, 200) selon l'une des revendications précédentes, dans lequel les seconds moyens (116) aptes à générer le quatrième signal comportent au moins une boucle à verrouillage de phase apte à générer en sortie (150) le quatrième signal.

**7.** Dispositif (100, 200) selon la revendication 6, dans lequel la boucle à verrouillage de phase comporte au moins :

- un premier comparateur de phases (138) apte à comparer une phase du troisième signal *ref(t-τ)* obtenu à la seconde extrémité (108) de la première liaison de transmission (104, 124.1, 124.2) et une phase du quatrième signal obtenu en sortie (150) de la boucle à verrouillage de phase,
- un second comparateur de phases (140) apte à comparer une phase du deuxième signal *ref(t+τ)* obtenu en sortie (136) desdits premiers moyens (114) et une phase du quatrième signal obtenu en sortie (150) de la boucle à verrouillage de phase,
- des moyens d'addition (142) de signaux obtenus en sortie du premier (138) et du second (140) comparateur de phases,
- un atténuateur (144, 146) du signal obtenu en sortie des moyens d'addition (142), de gain égal à environ 0,5,
- un filtre passe-bas (146) apte à filtrer le signal obtenu en sortie des moyens d'addition (142),
- un oscillateur commandé en tension (148) comprenant une entrée reliée à une sortie du filtre passe-bas (146) et une sortie correspondant à la sortie (150) de la boucle à verrouillage de phase et couplée à une entrée du premier comparateur de phases (138) et à une entrée du second comparateur de phases (140).

**8.** Dispositif (100, 200) selon la revendication 7, dans lequel la sortie de l'oscillateur commandé en tension (148) de la boucle à verrouillage de phase est directement reliée auxdites entrées du premier (138) et du second (140) comparateur de phases, ou dans lequel la boucle à verrouillage de phase comporte en outre un diviseur de fréquence (152) dont une entrée est reliée à la sortie de l'oscillateur commandé en tension (148) et dont une sortie est reliée auxdites entrées du premier (138) et du second (140) comparateur de phases, le premier (138) et le second (140) comparateur de phases étant dans ce cas respectivement aptes à comparer une phase du troisième signal *ref(t-τ)* et une phase du deuxième signal *ref(t+τ)* avec une phase du signal obtenu en sortie du diviseur de fréquence (152).

**9.** Dispositif (100, 200) selon l'une des revendications 1 à 5, dans lequel les seconds moyens (116) aptes à générer le quatrième signal comportent au moins une boucle à verrouillage de retard apte à générer en sortie (150) le quatrième signal.

**10.** Dispositif (100, 200) selon la revendication 9, dans lequel la boucle à verrouillage de retard comporte au moins :

- un premier comparateur de phases (138) apte à comparer une phase du troisième signal *ref(t-τ)* obtenu à la seconde extrémité (108) de la première liaison de transmission (104, 124.1, 124.2) et une phase du quatrième signal obtenu en sortie (150) de la boucle à verrouillage de retard,
- un second comparateur de phases (140) apte à comparer une phase du deuxième signal *ref(t+τ)* obtenu en sortie (136) desdits premiers moyens (114) et une phase du quatrième signal obtenu en sortie (150) de la boucle à verrouillage de retard,
- des moyens d'addition (142) de signaux obtenus en sortie du premier (138) et du second (140) comparateur de phases,
- un atténuateur (144) du signal obtenu en sortie des moyens d'addition (142), de gain égal à environ 0,5,
- un filtre passe-bas (146) apte à filtrer le signal obtenu en sortie des moyens d'addition (142),

- une ligne à retards commandée en tension (154) comprenant une première entrée reliée à une sortie du filtre passe-bas (146), une seconde entrée sur laquelle le deuxième signal *ref(t+τ)* ou le troisième signal *ref(t-τ)* est destiné à être appliqué, et une sortie correspondant à la sortie (150) de la boucle à verrouillage de retard et couplée à une entrée du premier comparateur de phases (138) et à une entrée du second comparateur de phases (140).

11. Dispositif (100, 200) selon la revendication 10, dans lequel la sortie de la ligne à retards commandée en tension (154) de la boucle à verrouillage de retard des seconds moyens (116) est directement reliée auxdites entrées du premier (138) et du second (140) comparateur de phases.

12. Dispositif (200) selon l'une des revendications précédentes, ledit dispositif (200) étant apte à compenser *n* délais $\tau_1$ à $\tau_n$ subis par n premiers signaux $ref_1(t)$ à $ref_n(t)$ lors d'une propagation entre des premières et des secondes extrémités de *n* premières liaisons de transmission (104.1 - 104.n), *n* étant un nombre entier supérieur ou égal à 2, dans lequel les premiers moyens (114) aptes à générer le deuxième signal *ref(t+τ),* τ étant égal à la moyenne des n délais $\tau_1$ à $\tau_n$, comportent :

- *n* comparateurs de phases (118.1 - 118.n), chacun étant apte à comparer une phase d'un des n premiers signaux $ref_1(t)$ à $ref_n(t)$ et une phase d'un signal obtenu à une première extrémité d'une deuxième liaison de transmission (124) apte à retarder d'un délai sensiblement égal à τ un signal propagé sur ladite deuxième liaison de transmission (124),
- *n* troisièmes liaisons de transmission (126.1 - 126.n), chacune étant apte à retarder d'un des délais $\tau_1$ à $\tau_n$ un signal propagé sur ladite troisième liaison de transmission (126.1 - 126.n), comprenant une première extrémité reliée à une sortie d'un des n comparateurs de phases (118.1 - 118.n) et une deuxième extrémité reliée à une entrée de moyens d'addition (119) de signaux,
- un atténuateur (119) du signal obtenu en sortie des moyens d'addition (119), de gain égal à environ 1/n,
- un filtre passe-bas (120) apte à filtrer le signal obtenu en sortie des moyens d'addition (119) ;
- un oscillateur commandé en tension (122) dont une entrée est reliée à une sortie du filtre passe-bas (120) et dont une sortie, correspondant à une sortie desdits premiers moyens (114), est couplée à une deuxième extrémité de la deuxième liaison de transmission (124),

ledit dispositif (200) comportant en outre au moins une boucle à verrouillage de phase (202) ou une boucle à verrouillage de retard comportant n entrées reliées aux deuxièmes extrémités des n premières liaisons de transmission (104.1 - 104.n) et apte à délivrer le troisième signal *ref(t-τ)*.

13. Dispositif (200) selon l'une des revendications 1 à 11, ledit dispositif (200) étant apte à compenser n délais $\tau_1$ à $\tau_n$, subis par n premiers signaux $ref_1(t)$ à $ref_n(t)$ lors d'une propagation entre des premières et des secondes extrémités de n premières liaisons de transmission (104.1 - 104.n), n étant un nombre entier supérieur ou égal à 2, dans lequel les premiers moyens (114) aptes à générer le deuxième signal *ref(t+τ),* τ étant égal à la moyenne des n délais $\tau_1$ à $\tau_n$, comportent :

- n comparateurs de phases (118.1 - 118.n), chacun étant apte à comparer une phase d'un des n premiers signaux $ref_1(t)$ à $ref_n(t)$ et une phase d'un signal obtenu à une première extrémité d'une deuxième liaison de transmission (124) apte à retarder d'un délai sensiblement égal à τ un signal propagé sur ladite deuxième liaison de transmission (124),
- n troisièmes liaisons de transmission (126.1 - 126.n), chacune étant apte à retarder d'un des délais $\tau_1$ à $\tau_n$, un signal propagé sur ladite troisième liaison de transmission (126.1 - 126.n), comprenant une première extrémité reliée à une sortie d'un des n comparateurs de phases (118.1 - 118.n) et une deuxième extrémité reliée à une entrée de moyens d'addition (119) de signaux,
- un atténuateur du signal obtenu en sortie des moyens d'addition (119), de gain égal à environ 1/n,
- un filtre passe-bas (120) apte à filtrer le signal obtenu en sortie des moyens d'addition (119),
- une ligne à retards commandée en tension comprenant une première entrée reliée à une sortie du filtre passe-bas (120) et une seconde entrée sur laquelle l'un des n premiers signaux $ref_1(t)$ à $ref_n(t)$ est destiné à être appliqué, et dont une sortie, correspondant à une sortie desdits premiers moyens (114), est couplée à une deuxième extrémité de la deuxième liaison de transmission (124),

ledit dispositif (200) comportant en outre au moins une boucle à verrouillage de phase (202) ou une boucle à verrouillage de retard comportant n entrées reliées aux deuxièmes extrémités des n premières liaisons de transmission (104.1 - 104.n) et apte à délivrer le troisième signal *ref(t-τ)*.

**14.** Dispositif (1000, 2000) de distribution d'au moins un signal d'horloge *ref(t),* comportant plusieurs liaisons de transmission sur lesquelles le signal d'horloge *ref(t)* ou un signal synchronisé avec le signal d'horloge *ref(t)* est destiné à être propagé, et une pluralité de dispositifs (100, 200) de compensation de délai selon l'une des revendications 1 à 13 couplés auxdites liaison de transmissions et aptes à compenser les délais de propagation des signaux sur lesdites liaisons de transmission.

**15.** Dispositif (1000, 2000) selon la revendication 14, comportant en outre au moins un dispositif de génération du signal d'horloge *ref(t).*

**16.** Dispositif (2000) selon l'une des revendications 14 ou 15, comportant au moins une boucle à phase asservie (2004) apte à délivrer en sortie un signal d'horloge dont la phase est synchronisée par rapport à une moyenne de phases de plusieurs signaux délivrés par lesdits dispositifs de compensation de délai (100, 200).

**17.** Dispositif (2000) selon l'une des revendications 14 à 16, comportant en outre au moins deux dispositifs (100, 200) de compensation de délai couplés entre eux tels que :

- une sortie des premiers moyens (114.1) aptes à générer un deuxième signal d'un premier des deux dispositifs (100, 200) de compensation de délai est couplée à une entrée des seconds moyens (116.2) aptes à générer un quatrième signal d'un second des deux dispositifs (100, 200) de compensation de délai,
- une sortie des premiers moyens (114.2) aptes à générer un deuxième signal du second des deux dispositifs (100, 200) de compensation de délai est couplée à une entrée des seconds moyens (116.2) aptes à générer un quatrième signal du premier des deux dispositifs (100, 200) de compensation de délai.

**18.** Procédé de compensation d'un délai $\tau$ subi par un premier signal *ref(t)* périodique lors d'une propagation entre une première (106) et une seconde extrémité (108) d'une première liaison de transmission (104, 124.1, 124.2), comportant au moins les étapes de :

- génération d'un deuxième signal *ref(t+$\tau$)* correspondant au premier signal *ref(t)* dont la phase est avancée d'une durée égale au délai $\tau$,
- génération, à partir d'un troisième signal *ref(t-$\tau$)* obtenu à la seconde extrémité de la première liaison de transmission (104, 124.1, 124.2) et correspondant au premier signal *ref(t)* dont la phase est retardée du délai $\tau$, et à partir du deuxième signal *ref(t+$\tau$),* d'un quatrième signal en phase avec le premier signal *ref (t).*

FIG.1

FIG.2

FIG.3

FIG.4

FIG.5

$$\varphi_{ref} = \varphi_{div} - \tau \Rightarrow \varphi_{div} = \varphi_{ref} + \tau$$

FIG.6

FIG.7A

FIG.7B

**FIG.8**

**FIG.9**

$$\varphi_{ref} - \tau$$

$$\varphi_{div} = \varphi_{ref} + \tau$$

$$\frac{1}{2}$$

$$\varphi_{ref}$$

$$\varepsilon_\Sigma = 0$$

$$F(s)$$

$$K_{vco}/s$$

$$\varphi_{clk} = \varphi_{ref}$$

**FIG.10**

FIG.11A

FIG.11B

FIG.12

FIG.13

FIG.14

FIG.15

Europäisches
Patentamt

European
Patent Office

Office européen
des brevets

**RAPPORT DE RECHERCHE EUROPEENNE**

Numéro de la demande

EP 11 19 2350

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | GB 2 129 634 A (CONTROL DATA CORP) 16 mai 1984 (1984-05-16) | 1,18 | INV. G06F1/10 |
| A | * figures 3,4 * * page 2, ligne 27 - ligne 88 * | 2-17 | H03L7/00 H04L7/00 |
| A | US 2005/129158 A1 (KUWATA NAOKI [JP]) 16 juin 2005 (2005-06-16) * figure 5 * * alinéa [0039] - alinéa [0042] * | 1-18 | |
| A | HYUN-WOO LEE ET AL: "A 1.6V 3.3Gb/s GDDR3 DRAM with dual-mode phase and delay-locked loop using power-noise management with unregulated power supply in 54nm CMOS", SOLID-STATE CIRCUITS CONFERENCE - DIGEST OF TECHNICAL PAPERS, 2009. ISSCC 2009. IEEE INTERNATIONAL, IEEE, PISCATAWAY, NJ, USA, 8 février 2009 (2009-02-08), pages 140-141,141A, XP031466040, ISBN: 978-1-4244-3458-9 * page 140, colonne de gauche, dernier alinéa - colonne de droite, alinéa 1 * | 1,18 | DOMAINES TECHNIQUES RECHERCHES (IPC) G06F H04L H03L |

Le présent rapport a été établi pour toutes les revendications

| Lieu de la recherche | Date d'achèvement de la recherche | Examinateur |
|---|---|---|
| La Haye | 16 avril 2012 | Pieper, Thomas |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 11 19 2350

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-04-2012

| Document brevet cité au rapport de recherche | Date de publication | Membre(s) de la famille de brevet(s) | Date de publication |
|---|---|---|---|
| GB 2129634 A | 16-05-1984 | AUCUN | |
| US 2005129158 A1 | 16-06-2005 | JP 3974618 B2<br>US 2005129158 A1<br>WO 2004040835 A1 | 12-09-2007<br>16-06-2005<br>13-05-2004 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7571359 B

**Littérature non-brevet citée dans la description**

- **HONG-YEAN HSIEH et al.** Self-calibrating clock distribution with scheduled skews. *Proc. ISCAS,* 1998, 470-473